# EUROPEAN PATENT APPLICATION

(11) **EP 4 421 218 A1**
(43) Date of publication of application: **28.08.2024**
(21) Application number: 22923683.1
(22) Date of filing: 30.12.2022
(51) Int. Cl.: C30B 29/06, C30B 15/20

(54) **COOLING DEVICE AND CONTROL METHOD THEREFOR, AND CRYSTAL GROWTH APPARATUS**

(30) Priority: 29.01.2022 CN 202210112239
(71) Applicant: Zhonghuan Advanced Semiconductor Technology Co., Ltd., Wuxi, Jiangsu 214203 (CN)
(72) Inventor: WANG, Shuangli, Xuzhou, Jiangsu 221001 (CN); CHEN, Chun-Hung, Xuzhou, Jiangsu 221001 (CN); WU, Wei, Xuzhou, Jiangsu 221004 (CN)
(74) Representative: Grassi, Stefano
(86) International application number: PCT/CN2022/144251
(87) International publication number: WO 2023/142898

(57) **Abstract**

Disclosed are a cooling device and a control method therefor, and a crystal growth apparatus. The cooling device (1) is used for the crystal growth apparatus (100) and is used for cooling a crystal (101), and a top of the crystal (101) is provided with a crystal crown (101a). The cooling device (1) includes a first cooling jacket (11) and a second cooling jacket (12), wherein the first cooling jacket (11) is configured to be fixedly connected with a crystal pulling mechanism (4) of the crystal growth apparatus (100) and covers an upper side of the crystal crown (101a), and an inner wall face of the first cooling jacket (11) is spaced from a surface of the crystal (101); the second cooling jacket (12) is formed into a cylindrical structure and is fixedly arranged in a furnace body (2) of the crystal growth apparatus (100), an orthographic projection of the second cooling jacket (12) is nested outside an orthographic projection of the first cooling jacket (11) in a cross-section of the cooling device (1), and the second cooling jacket (12) is used for cooling different parts of the crystal (101) during a growth process of the crystal (101); and an axial length of the first cooling jacket (11) is less than an axial length of the second cooling jacket (12).

## Description

### Cross-Reference to Related Application

The present application claims priority to Chinese Patent Application No. 202210112239.2, filed to the China National Intellectual Property Administration on January 29, 2022 and entitled "Cooling Device and Control Method therefor, and Crystal Growth Apparatus".

### Technical Field

The present invention relates to the technical field of crystal production devices, and in particular to a cooling device and a control method therefor, and a crystal growth apparatus.

### Background

A crystal growth apparatus, such as a single crystal furnace, is usually provided with a cooling device for cooling a crystal. However, in the related art, the cooling device is far away from a solid-liquid interface in an early growth stage of the crystal, so that the cooling effect of the cooling device in the early growth stage of the crystal is poor, especially the cooling effect on a crystal diameter or a crystal crown of the crystal cannot meet the requirements.

### Summary

The present invention aims to at least solve one of the technical problems existing in the related art. To this end, the present invention provides a cooling device, which effectively ensures the cooling requirement during the entire growth process of a crystal, especially the cooling requirement of a crystal crown in the early growth stage of the crystal.

The present invention further provides a crystal growth apparatus provided with the above cooling device.

The present invention further provides a control method for the cooling device.

A cooling device according to an embodiment in a first aspect of the present invention is provided, the cooling device is used for a crystal growth apparatus and used for cooling a crystal, and a top of the crystal is provided with a crystal crown. The cooling device includes a first cooling jacket and a second cooling jacket. The first cooling jacket is configured to be fixedly connected with a crystal pulling mechanism of the crystal growth apparatus and covers an upper side of the crystal crown, the first cooling jacket rises along with a lifting of the crystal pulling mechanism during a growth process of the crystal, an inner wall face of the first cooling jacket is spaced from a surface of the crystal, and the first cooling jacket defines at least one first cooling channel. The second cooling jacket is formed into a cylindrical structure, and is configured to be fixedly arranged in a furnace body of the crystal growth apparatus, an orthographic projection of the second cooling jacket is nested outside an orthographic projection of the first cooling jacket in a cross-section of the cooling device, the second cooling jacket defines a second cooling channel, and is used for cooling different parts of the crystal during the growth process of the crystal. An axial length of the first cooling jacket is less than an axial length of the second cooling jacket.

Through the cooling device according to the embodiment of the present invention, the cooling device includes the first cooling jacket and the second cooling jacket, and the first cooling jacket is configured to cover the upper side of the crystal crown to cool the crystal crown, and the second cooling jacket is used for cooling different parts of the crystal during the growth process of the crystal, thereby effectively ensuring the cooling requirement during the entire growth process of the crystal, especially the cooling requirement of the crystal crown in the early growth stage of the crystal.

In some embodiments, a first through hole is formed on the first cooling jacket, and the crystal pulling mechanism is configured to pass through the first through hole.

In some embodiments, a plurality of second through holes are formed at a top of the first cooling jacket, and the plurality of second through holes are arranged at intervals in a circumferential direction of the cooling device, so that a protective gas flows into a space between the cooling device and the crystal through the second through holes.

In some embodiments, the first cooling jacket includes a first cooling part and a second cooling part. The first cooling part is formed into a cylindrical structure, and defines the first cooling channel. The second cooling part covers an upper end of the first cooling part, and is fixedly connected with the crystal pulling mechanism, the second cooling part defines the first cooling channel, and the first cooling channel of the second cooling part and the first cooling channel of the first cooling part are independently arranged.

In some embodiments, a shape of an inner wall face of the second cooling part is consistent with a shape of a surface of the crystal crown.

In some embodiments, at least one of an outer peripheral wall of the first cooling part and an inner peripheral wall of the second cooling jacket is formed into a curve segment in a longitudinal section of the cooling device.

In some embodiments, the second cooling jacket is configured to be fixedly arranged in the furnace body of the crystal growth apparatus.

In some embodiments, an outer peripheral wall of the second cooling jacket is provided with a heat dissipation structure.

In some embodiments, the heat dissipation structure includes a plurality of heat dissipation groups sequentially arranged in an axial direction of the second cooling jacket. For at least two adjacent heat dissipation groups, a heat dissipation area per unit length of the heat dissipation group on a lower side in the axial direction of the second cooling jacket is greater than a heat dissipation area per unit length of the heat dissipation group on an upper side in the axial direction of the second cooling jacket.

In some embodiments, the heat dissipation structure includes at least one fin group. Each fin group includes a plurality of heat dissipation fins. The plurality of heat dissipation fins of the fin group are arranged at intervals in an axial direction and/or a circumferential direction of the second cooling jacket.

A crystal growth apparatus according to an embodiment in a second aspect of the present invention includes a furnace body and the cooling device according to the embodiment in the first aspect of the present invention. The cooling device is arranged in the furnace body and is used for cooling the crystal.

Through adoption of the above cooling device, the crystal growth apparatus according to the embodiment of the present invention is convenient to ensure the cooling requirement during the entire growth process of the crystal, especially the cooling requirement in the early growth stage of the crystal.

A control method for a cooling device according to an embodiment in a third aspect of the present invention is provided, the cooling device is the above cooling device according to the embodiment in the first aspect of the present invention. The control method includes following steps: S1, in a seeding stage, adjusting a flow rate of a medium in the first cooling channel, so that a temperature of a first preset position of the crystal is within a seeding temperature range, and adjusting a flow rate of a medium in the second cooling channel, so that a temperature of an outlet of the first cooling channel is within a preset temperature range.

The control method for the cooling device according to the embodiment of the present invention is convenient to effectively ensure the cooling requirement in the early growth stage of the crystal, especially the cooling requirement in the seeding stage.

In some embodiments, the first cooling jacket includes a first cooling part and a second cooling part. The first cooling part is formed into a cylindrical structure, and defines the first cooling channel. The second cooling part covers an upper end of the first cooling part, and is fixedly connected with the crystal pulling mechanism, the second cooling part defines the first cooling channel, and the first cooling channel of the second cooling part and the first cooling channel of the first cooling part are independently arranged.

In some embodiments, in S1, a flow rate of a medium in the first cooling part is equal to a flow rate of a medium in the second cooling part.

In some embodiments, the control method further includes: S2, in a necking stage and a shouldering and shoulder turning stage, adjusting the flow rate of the medium in the first cooling channel of the second cooling part according to a temperature of a second preset position and a degree of growth of the crystal crown; S3, in an early equal-diameter stage, increasing the flow rate of the medium in the first cooling channel of the second cooling part to a maximum flow rate, adjusting the flow rate of the medium in the first cooling channel of the first cooling part according to the temperature of the second preset position and a growth state of the crystal, and adjusting the flow rate of the medium in the second cooling channel according to the temperature of the outlet of the first cooling channel; S4, in an intermediate equal-diameter stage, maintaining the flow rate of the medium in the first cooling channel of the second cooling part at the maximum flow rate, wherein the flow rate of the medium in the first cooling channel of the first cooling part is equal to the flow rate of the medium in the first cooling channel of the first cooling part at an end of the early equal-diameter stage, and adjusting the flow rate of the medium in the second cooling channel according to the temperature of the second preset position and the growth state of the crystal; S5, in an equal-diameter ending stage, adjusting the flow rate of the medium in the first cooling channel according to the temperature of the outlet of the first cooling channel, and adjusting the flow rate of the medium in the second cooling channel according to the temperature of the second preset position and the growth state of the crystal; and S6, in an ending stage, adjusting the flow rate of the medium in the first cooling channel according to the temperature of the outlet of the first cooling channel.

Additional aspects and advantages of the present invention will be given in part in the following description, and in part will become apparent from the following description, or be learned through the practice of the present invention.

### Brief Description of the Drawings

The above and/or additional aspects and advantages of the present invention will become apparent and easy to understand from the accompanying drawings below with reference to the description of the embodiments.
Fig. 1 is a partial schematic diagram of a crystal growth apparatus according to an embodiment of the present invention.
Fig. 2 is a schematic diagram of a first cooling jacket shown in Fig. 1.
Fig. 3 is a schematic diagram of a second cooling jacket shown in Fig. 1.
Fig. 4 is section view of a cooling device shown in Fig. 1.
Fig. 5 is a schematic diagram of a second cooling jacket according to another embodiment of the present invention.
Fig. 6 is a flowchart of a control method for the cooling device according to an embodiment of the present invention.

### Reference signs are as follows.

Crystal growth apparatus 100; Crystal 101; Crystal crown 101a; Solid-liquid interface 101b;
Cooling device 1;
First cooling jacket 11; First through hole 11a; Second through hole 11b;
First curve segment 110; First protrusion 110a; First recess 110b;
First cooling part 111; Second cooling part 112;
Second cooling jacket 12; Second curve segment 120; Second protrusion 120a; Second recess 120b;
Heat dissipation structure 13; Heat dissipation group 131; Fin group 132;
Furnace body 2; Crucible 3; Crystal pulling mechanism 4; and Guide cylinder 5.

### Detailed Description of the Embodiments

Embodiments of the present invention are described in detail below, examples of the embodiments are shown in the accompanying drawings, wherein the same or similar reference signs throughout refer to the same or similar elements or elements having the same or similar functions. The embodiments described below with reference to the accompanying drawings are exemplary and are only used to explain the present invention, and are not to be construed as limiting the present invention.

The following invention provides various different embodiments or examples for implementing different structures of the present invention. In order to simplify the invention of the present invention, components and settings of specific examples are described below. They are, of course, examples only and are not intended to limit the present invention. In addition, the present invention may repeat reference numbers and/or letters in different examples. This repetition is for the purposes of simplification and clarity and does not in itself indicate the relationship between the various embodiments and/or settings discussed. In addition, examples of various specific processes and materials are provided in the present invention, but those of ordinary skill in the art may realize the applicability of other processes and/or the use of other materials.

A cooling device 1 according to an embodiment of the present invention is described below with reference to the accompanying drawings.

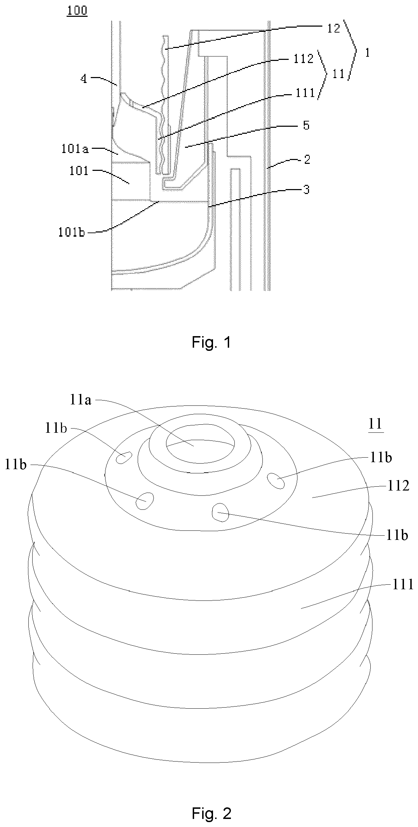

As shown in Fig. 1, the cooling device 1 is used for a crystal growth apparatus 100, and the cooling device 1 is used for cooling a crystal 101, so that the cooling device 1 may affect the thermal field distribution in the crystal growth apparatus 100 and the temperature gradient at a solid-liquid interface 101b of a melt of the crystal growth apparatus 100, thereby affecting the diameter of the crystal 101 and the growth quality of the crystal 101.

As shown in Fig. 1 to Fig. 3, a top of the crystal 101 is provided with a crystal crown 101a. The cooling device 1 includes a first cooling jacket 11. The first cooling jacket 11 is configured to be fixedly connected with a crystal pulling mechanism 4 of the crystal growth apparatus 100, and the first cooling jacket 11 is configure to cover an upper side of the crystal crown 110a. During a growth process of the crystal 101, the crystal pulling mechanism 4 may control the rising speed of a seed crystal to pull out the crystal 101 on the basis of the seed crystal, and then the first cooling jacket 11 may be driven by the crystal pulling mechanism 4 to move upwards along with the seed crystal during the growth process of the crystal 101, that is, the first cooling jacket 11 rises along with the lifting of the crystal pulling mechanism 4, so that the first cooling jacket 11 may always cover the crystal crown 101a during the growth process of the crystal 101, thereby making the first cooling jacket 11 cool the crystal crown 101a during the growth process of the crystal 101, reducing a thermal radiation angle coefficient of the crystal crown 101a and the cooling device 1, increasing the effective heat radiation area, and further enhancing the heat dissipation of the crystal crown 101a.

Wherein, the first cooling jacket 11 defines at least one first cooling channel, and a cooling medium may be provided in the first cooling channel to absorb the heat of the crystal crown 101a to reduce the temperature of the crystal crown 101a.

It is apparent that during the early growth stage of the crystal, the first cooling jacket 11 is located above the solid-liquid interface 101b, and the first cooling jacket 11 is close to the solid-liquid interface 101b, for example, the first cooling jacket 11 is fixedly connected with a lower end of the crystal pulling mechanism 4, so as to facilitate the cooling of the crystal 101 in the early growth stage of the crystal, which is conducive to improving the perfect crystal rate of the crystal 101, and along with the growth of the crystal 101, the crystal crown 101a is gradually formed, and the crystal crown 101a gradually moves upwards, and the first cooling jacket 11 moves along with the crystal crown 101a, so as to achieve the cooling of the crystal crown 101a during the subsequent growth process of the crystal.

It is understandable that when the first cooling jacket 11 defines a plurality of first cooling channels, the plurality of first cooling channels may be connected in series and/or in parallel. It is to be noted that "and/or" in the description of the present invention means that three parallel solutions are included. Taking "A and/or B" as an example, a solution A, or a solution B, or a solution that A and B are met at the same time are included.

As shown in Fig. 1 to Fig. 3, the cooling device 1 further includes a second cooling jacket 12. The second cooling jacket 12 is formed into a cylindrical structure, and an orthographic projection of the second cooling jacket 12 is nested outside an orthographic projection of the first cooling jacket 11 in a cross-section of the cooling device 1, so that the second cooling jacket 12 is configured to be nested outside the crystal 101 during the growth process of the crystal 101. The second cooling jacket 12 is used for cooling different parts of the crystal 101 during the growth process of the crystal 101, so that during the growth process of the crystal 101, the second cooling jacket 12 and the crystal 101 may move relative to each other in an axial direction of the crystal 101, and then the second cooling jacket 12 may be opposite to different parts of the crystal 101.

Wherein, the second cooling jacket 12 is configured to be fixedly arranged in a furnace body 2 of the crystal growth apparatus 100, which is conducive to simplifying the installation of the second cooling jacket 12. During the growth process of the crystal 101, the crystal 101 gradually grows and moves upwards under the lifting of the crystal pulling mechanism 4, so as to achieve the relative movement of the crystal 101 and the second cooling jacket 12, and ensure that the second cooling jacket 12 cools different parts of the crystal 101.

The cross-section of the cooling device 1 is perpendicular to a central axis of the cooling device 1. The second cooling jacket 12 defines a second cooling channel, a cooling medium may be provided in the second cooling channel to absorb the heat of the crystal 101 and reduce the temperature of the crystal 101.

Wherein, in the example shown in Fig. 1, an axial length of the first cooling jacket 11 is less than an axial length of the second cooling jacket 12. The first cooling jacket 11 is mainly used for cooling the crystal crown 101a, so that the axial length of the first cooling jacket 11 may be appropriately reduced to save the material consumption of the first cooling jacket 11 and reduce the material cost and the machining cost of the first cooling jacket 11 on the premise of meeting the heat dissipation requirement of the crystal crown 101a, and the second cooling jacket 12 is mainly used for cooling different parts of the crystal 101, so that the axial length of the second cooling jacket 12 is set relatively long, which is conducive to improving the heat dissipation capacity of the second cooling jacket 12, thereby improving the heat dissipation efficiency of the second cooling jacket 12 to better meet the heat dissipation requirement of the crystal 101.

It is understandable that the specific position of the second cooling jacket 12 in the axial direction of the cooling device 1 may be specifically set according to actual requirements, for example, in the example of Fig. 1, the central axis of the cooling device 1 extends vertically, and the height position of the second cooling jacket 12 may be specifically set according to actual requirements.

It can be seen that the second cooling jacket 12 may always be nested outside the first cooling jacket 11 during the growth process of the crystal 101, at this time, no matter how the first cooling jacket 11 and the second cooling jacket 12 move relative to each other, the first cooling jacket 11 is located in the second cooling jacket 12. Or in some time periods, the second cooling jacket 12 is nested outside the first cooling jacket 11, and in other time periods, at least part of the first cooling jacket 11 extends out of the second cooling jacket 12.

Therefore, during the growth process of the crystal, the first cooling jacket 11 and the second cooling jacket 12 may move relative to each other in the axial direction of the cooling device 1, so that the cooling device 1 may better meet the actual heat dissipation requirement of the crystal 101, and the first cooling jacket 11 and the second cooling jacket 12 do not interfere with each other when moving relative to each other.

Through the cooling device 1 according to the embodiment of the present invention, the cooling device 1 includes the first cooling jacket 11 and the second cooling jacket 12, and the first cooling jacket 11 is configured to cover the upper side of the crystal crown 101a to cool the crystal crown 101a, and the second cooling jacket 12 is used for cooling different parts of the crystal 101 during the growth process of the crystal 101, thereby effectively ensuring the cooling requirement during the entire growth process of the crystal 101, especially ensuring the cooling requirement of the crystal crown 101a in the early growth stage of the crystal 101.

Compared with some technical solutions, in order to ensure the cooling efficiency of the crystal 101 in the early growth stage of the crystal, the axial length of the cooling device 1 is set relatively long, so that a distance between the lower end of the cooling device 1 and the solid-liquid interface 101b is relatively small. In the present invention, the first cooling jacket 11 is fixedly connected with the crystal pulling mechanism 4 and covers the upper side of the crystal crown 101a, so that the first cooling jacket 11 moves upwards along with the crystal pulling mechanism 4 during the crystal pulling process, so as to facilitate the heat dissipation of the crystal 101 (or crystal crown 101a) in the early growth stage of the crystal and the heat dissipation of the crystal crown 101a during the growth process of the crystal, without setting the cooling device relatively long, which is conductive to saving the space occupied by the cooling device 1 in the crystal growth apparatus 100 and simplifying the structure of the cooling device 1.

Optionally, a cooling liquid (e.g. water, etc.) and/or a cooling gas are/is provided in the first cooling channel, and a cooling liquid and/or a cooling gas are/is provided in the second cooling channel. For example, the cooling liquid and the cooling gas are provided in the first cooling channel, at this time, the first cooling channel may include a first sub-channel and a second sub-channel isolated from each other. The first sub-channel is formed into an airflow channel, the second sub-channel is formed into a cooling liquid channel, the airflow channel may be provided with an air outlet, the air outlet is configured to blow the cooling gas towards the crystal, and heat exchange exists between the cooling liquid channel and the airflow channel, for example, the cooling liquid channel may be used for cooling the airflow channel.

It is understandable that the specific shapes of the first cooling channel and the second cooling channel may be specifically set according to actual requirements, for example, at least one of the first cooling channel and the second cooling channel may spirally extend in the axial direction of the cooling device.

In some embodiments, as shown in Fig. 1 and Fig. 2, a first through hole 11a is formed on the first cooling jacket 11, and the crystal pulling mechanism 4 is configured to pass through the first through hole 11a, so that the lower end of the crystal pulling mechanism 4 may pass through the first through hole 11a to be fixedly connected with the seed crystal. It can be seen that the first through hole 11a may avoid the crystal pulling mechanism 4, and the first cooling jacket 11 does not need to be provided with a connecting structure to connect the crystal pulling mechanism 4 and the seed crystal, which is conductive to simplifying the structure of the first cooling jacket 11.

In some embodiments, as shown in Fig. 2, a plurality of second through holes 11b are formed at a top of the first cooling jacket 11, and the plurality of second through holes 11b are arranged at intervals in a circumferential direction of the cooling device 1, so that a protective gas in the crystal growth apparatus 100 flows into a space between the cooling device 1 and the crystal 101 through the second through holes 11b. When the cooling device 1 is used in the crystal growth apparatus 100, in order to ensure the atmosphere in the crystal growth apparatus 100, it is usually necessary to introduce the protective gas (e.g. inert gas) into the crystal growth apparatus 100, and the protective gas may flow into the space between the cooling device 1 and the crystal 101 through the second through holes 11b, so as to ensure the atmosphere around the crystal 101, ensure a relatively stable flow field around the crystal 101, avoid a large change in the flow field of the protective gas caused by the influence of the first cooling jacket 11, ensure a relatively stable temperature gradient at the solid-liquid interface and a relatively uniform change in the temperature gradient, and ensure a relatively stable shape of the solid-liquid interface, thereby effectively controlling the distribution of crystal micro-defects, and at the same time, the flow of the protective gas may take away a part of the heat of the crystal 101 and the cooling device 1 in time, which is conductive to improving the cooling effect on the crystal 101.

It is understandable that the number and shape of the second through holes 11b may be specifically set according to actual requirements.

In the description of the present invention, the circumferential direction of the cooling device 1 is a direction around the central axis of the cooling device 1, and the circumferential direction of the cooling device 1 is perpendicular to the axial direction of the cooling device.

Optionally, in the examples of Fig. 1 and Fig. 2, a central axis of the first cooling jacket 11 coincides with a central axis of the crystal 101, or a distance between the central axis of the first cooling jacket 11 and the central axis of the crystal 101 is relatively small, and a distance between an orthographic projection of the second through hole 11b and the central axis of the crystal 101 is less than a diameter of the crystal 101 in the cross-section of the first cooling jacket 11.

In some embodiments, as shown in Fig. 1 and Fig. 2, the first through hole 11a and the plurality of second through holes 11b are formed on the first cooling jacket 11, the plurality of second through holes 11b are located on a radial outer side of the first through hole 11a, the plurality of second through holes 11b are arranged at intervals in the circumferential direction of the first through hole 11a, the crystal pulling mechanism 4 is configured to pass through the first through hole 11a, and the protective gas in the crystal growth apparatus 100 is configured to flow into the space between the first cooling jacket 11 and the crystal 101 through the second through holes 11b.

In some embodiments, as shown in Fig. 1 and Fig. 2, the first cooling jacket 11 includes a first cooling part 111 and a second cooling part 112. The first cooling part 111 is formed into a cylindrical structure, and the first cooling part 111 defines the first cooling channel. The second cooling part 112 covers an upper end of the first cooling part 111, the second cooling part 112 is fixedly connected with the crystal pulling mechanism 4, and the second cooling part 112 defines the first cooling channel. Therefore, the first cooling jacket 11 is simple in structure and is convenient to achieve good and comprehensive cooling of the crystal crown 101a.

Wherein, the first cooling channel of the second cooling part 112 and the first cooling channel of the first cooling part 111 are independently arranged, so that the flow of a medium in the first cooling channel of the second cooling part 112 and the flow of a medium in the first cooling channel of the first cooling part 111 do not affect each other, which facilitates the regulation of the first cooling channel of the second cooling part 112 and the regulation of the first cooling channel of the first cooling part 111, respectively, to flexibly regulate the cooling capacity of the first cooling jacket 11, thereby better adapting to the cooling requirements of different growth stages of the crystal.

For example, the first cooling channel of the second cooling part 112 is provided with a first inlet and a first outlet, the first cooling channel of the first cooling part 111 is provided with a second inlet and a second outlet, and the first inlet and the second inlet are spaced apart and arranged independently, and the first outlet and the second outlet are spaced apart and arranged independently.

It is to be noted that, in the description of the present invention, the cross-section of the "cylindrical structure" may include, but is not limited to, a circular ring, an elliptical ring, a polygonal ring, and the like.

In some embodiments, as shown in Fig. 1 to Fig. 3, at least one of an outer peripheral wall of the first cooling part 111 and an inner peripheral wall of the second cooling jacket 12 is formed into a curve segment in a longitudinal section of the cooling device 1, including the following solutions: 1, the outer peripheral wall of the first cooling part 111 is formed into the curve segment in the longitudinal section of the cooling device 1; 2, the inner peripheral wall of the second cooling jacket 12 is formed into the curve segment in the longitudinal section of the cooling device 1; and 3, the outer peripheral wall of the first cooling part 111 and the inner peripheral wall of the second cooling jacket 12 are respectively formed into the curve segments in the longitudinal section of the cooling device 1. Therefore, the cooling area of at least one of the first cooling part 111 and the second cooling jacket 12 may be further increased, thereby further improving the cooling capability of at least one of the first cooling jacket 11 and the second cooling jacket 12.

The longitudinal section of the cooling device 1 is a plane passing through the central axis of the cooling device 1.

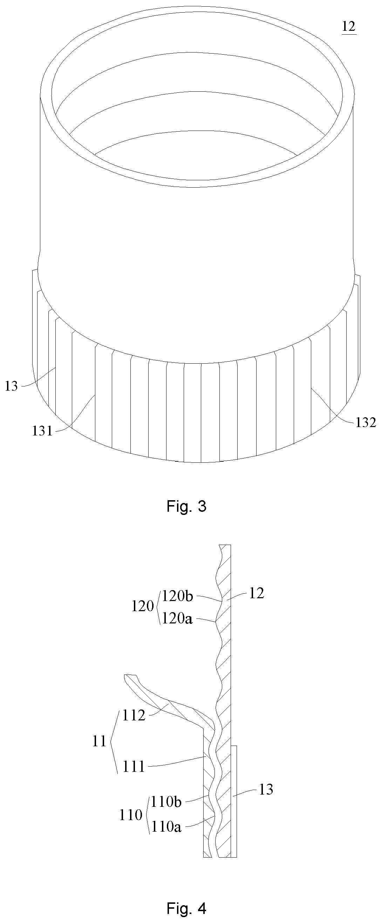

For example, in the example of Fig. 4, the outer peripheral wall of the first cooling part 111 is formed into a first curve segment 110 in the longitudinal section of the cooling device 1, and the first curve segment 110 includes a plurality of first protrusions 110a and a plurality of first recesses 110b, the plurality of first protrusions 110a and the plurality of first recesses 110b being alternately arranged in an axial direction of the first cooling part 111, so that one first recess 110b is arranged between two adjacent first protrusions 110a, and one first protrusion 110a is arranged between two adjacent first recesses 110b. The inner peripheral wall of the second cooling jacket 12 is formed into a second curve segment, and the second curve segment 120 includes a plurality of second protrusions 120a and a plurality of second recesses 120b, the plurality of second protrusions 120a and the plurality of second recesses 120b being alternately arranged in an axial direction of the second cooling jacket 12, so that one second recess 120b is arranged between two adjacent second protrusions 120a, and one second protrusion 120a is arranged between two adjacent second recesses 120b. It can be seen that both the outer peripheral wall of the first cooling part 111 and the inner peripheral wall of the second cooling jacket 12 are substantially formed into wavy line segments in the longitudinal section of the cooling device 1.

When the second cooling jacket 12 is fixedly arranged in the furnace body 2 of the crystal growth apparatus 100, during the growth process of the crystal 101, the first cooling jacket 11 moves upwards relative to the second cooling jacket 12, and the first curve segment 110 and the second curve segment 120 are both formed into the wavy line segments, so that the space between the first cooling jacket 11 and the second cooling jacket 12 may be effectively utilized on the premise of ensuring that the second cooling jacket 12 does not affect the movement of the first cooling jacket 11, so as to improve the cooling capacity of the first cooling jacket 11 and the second cooling jacket 12.

Wherein, during the growth process of the crystal, the relative positions of the first cooling part 111 and the second cooling jacket 12 have the following cases: the first protrusions 110a are radially opposite to the second recesses 120b, and the first recesses 110b are radially opposite to the second protrusions 120a, and at this time, the radial distance distribution between the outer peripheral wall of the first cooling part 111 and the inner peripheral wall of the second cooling jacket 12 is relatively balanced, which is conductive to shortening a heat transfer path between the entire first cooling part 111 and the second cooling jacket 12. For example, if the shape of the first curve segment 110 coincides with the shape of the second curve segment 120, in the above case, the radial distances of any positions between the outer peripheral wall of the first cooling part 111 and the inner peripheral wall of the second cooling jacket 12 are substantially equal, which effectively shortens the heat transfer path between the entire first cooling part 111 and the second cooling jacket 12, so that the second cooling jacket 12 quickly takes away the heat of the first cooling part 111 to further ensure the cooling effect on the crystal crown 101a.

In some embodiments, as shown in Fig. 1 and Fig. 2, a shape of the inner wall face of the second cooling part 112 is consistent with a shape of a surface of the crystal crown 101a, so that the second cooling part 112 performs relatively balanced cooling on the crystal crown 101a, which is conductive to making the temperature distribution on the surface of the crystal crown 101a relatively balanced, so that the temperature reduction rate of the surface of the crystal crown 101a remains substantially consistent.

For example, in the examples in Fig. 1 and Fig. 2, the first cooling jacket 11 is substantially formed into a bell-shaped structure.

In some embodiments, as shown in Fig. 1, Fig. 3, and Fig. 5, an outer peripheral wall of the second cooling jacket 12 is provided with a heat dissipation structure 13. The heat dissipation structure 13 may quickly dissipate the heat absorbed by the cooling medium in the second cooling channel, which is conductive to improving the cooling efficiency of the second cooling jacket 12 on the crystal 101, so as to achieve enhanced heat dissipation of the second cooling jacket 12 on the crystal 101.

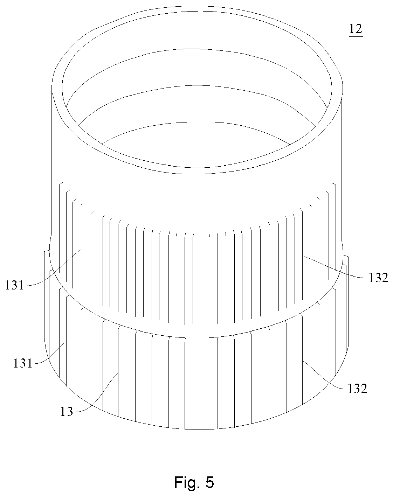

Optionally, in the examples of Fig. 3 and Fig. 5, the heat dissipation structure 13 and the second cooling jacket 12 are integrated. Of course, in other examples, the heat dissipation structure 13 and the second cooling jacket 12 are formed separately, and the heat dissipation structure 13 is installed on the second cooling jacket 12 by means of fixing.

In some embodiments, as shown in Fig. 5, the heat dissipation structure 13 includes a plurality of heat dissipation groups 131 sequentially arranged in the axial direction of the second cooling jacket 12. For at least two adjacent heat dissipation groups 131, a heat dissipation area per unit length of the heat dissipation group 131 on a lower side in the axial direction of the second cooling jacket 12 is greater than a heat dissipation area per unit length of the heat dissipation group131 on an upper side in the axial direction of the second cooling jacket 12, so that the heat dissipation efficiency of the heat dissipation group 131 on the lower side is greater than the heat dissipation efficiency of the heat dissipation group131 on the upper side under the same condition, and the temperature of the lower part of the crystal 101 is higher than the temperature of the upper part, so that the arrangement of the heat dissipation structure 13 may be better matched with the temperature distribution of the crystal 101, and the cooling requirement of the crystal 101, which is conductive to improving the cooling efficiency of the crystal 101.

In some embodiments, as shown in Fig. 3 and Fig. 5, the heat dissipation structure 13 includes at least one fin group 132. Each fin group 132 includes a plurality of heat dissipation fins. The plurality of heat dissipation fins of the fin group 132 are arranged at intervals in the axial direction of the second cooling jacket 12 and/or the circumferential direction of the second cooling jacket 12, including the following solutions: 1, the plurality of heat dissipation fins of the fin group 132 are arranged at intervals in the axial direction of the second cooling jacket 12, and at this time, the plurality of heat dissipation fins may extend in the circumferential direction of the second cooling jacket 12; 2, the plurality of heat dissipation fins of the fin group 132 are arranged at intervals in the circumferential direction of the second cooling jacket 12 (as shown in Fig. 3 and Fig. 5), and at this time, the plurality of heat dissipation fins may extend in the axial direction of the second cooling jacket 12; and 3, the plurality of heat dissipation fins of the fin group 132 are arranged at intervals in the axial direction and the circumferential direction of the second cooling jacket 12. Therefore, the heat dissipation structure 13 is simple in structure and flexible in arrangement, so as to ensure good heat dissipation efficiency.

It is understandable that the heat dissipation fin may extend along a straight line or a curve, a side wall of the heat dissipation fin may be a plane or a curved surface, and the shape of the cross-section of the heat dissipation fin may be specifically set according to actual requirements, for example, the shape of the cross-section of the heat dissipation fin may be a polygon (e.g. a triangle, a quadrilateral, or the like) or other irregular shapes.

In some embodiments, as shown in Fig. 5, the plurality of fin groups 132 are provided, and the plurality of fin groups 132 are sequentially arranged in the axial direction of the second cooling jacket 12. For at least two adjacent fin groups 132, the heat dissipation area per unit length of the fin group 132 on the lower side in the axial direction of the second cooling jacket 12 is greater than the heat dissipation area per unit length of the fin group 132 on the upper side in the axial direction of the second cooling jacket 12, so that the heat dissipation efficiency of the fin group 132 on the lower side is better than the heat dissipation efficiency of the fin group 132 on the upper side under the same condition, and the temperature of the lower part of the crystal 101 is higher than the temperature of the upper part, so that the arrangement of the fin group 132 may be better matched with the temperature distribution of the crystal 101, and the cooling requirement of the crystal 101, which is conductive to improving the cooling efficiency of the crystal 101.

For example, in the example of Fig. 5, the heat dissipation fins of each fin group 132 have the same structure, and the arrangement density of the plurality of heat dissipation fins of the fin group 132 on the lower side in the circumferential direction of the second cooling jacket 12 is greater than the arrangement density of the plurality of heat dissipation fins of the fin group 132 on the upper side in the circumferential direction of the second cooling jacket 12. Of course, differences in the heat dissipation area per unit length of the plurality of fin groups 132 in the axial direction of the second cooling jacket 12 may also be achieved by providing different structures of the heat dissipation fins of the plurality of fin groups 132.

Optionally, at least one of an inner side wall of the first cooling jacket 11, an outer side wall of the first cooling jacket 11, and an inner side wall of the second cooling jacket 12 is a graphite member, which facilitates preventing leakage of the cooling medium.

A crystal growth apparatus 100 according to an embodiment in a second aspect of the present invention includes a furnace body 2 and a cooling device 1. The cooling device 1 is arranged in the furnace body 2, and the cooling device 1 is used for cooling a crystal 101. Wherein, the cooling device 1 is the cooling device 1 according to the embodiment in the first aspect of the present invention.

For example, as shown in Fig. 1, a crucible 3 is arranged in the furnace body 2, the crucible 3 defines a containing space, and the cooling device 1 is located above the crucible 3.

Through the adoption of the above cooling device 1, the crystal growth apparatus 100 according to the embodiment of the present invention is convenient to ensure the cooling requirement during the entire growth process of the crystal 101.

As shown in Fig. 1, the crystal growth apparatus 100 further includes a guide cylinder 5. The second cooling jacket 12 is located on a radial inner side of the guide cylinder 5, and the outer peripheral wall of the second cooling jacket 12 and an inner peripheral wall of the guide cylinder 5 intersect at a non-zero angle in a longitudinal section of the crystal growth apparatus 100, that is, an included angle greater than zero is formed between the outer peripheral wall of the second cooling jacket 12 and the inner peripheral wall of the guide cylinder 5, so that the cooling capacity of the cooling device 1 is more matched with the cooling requirement of a crystal crown 101a.

A control method for a cooling device 1 according to an embodiment in a third aspect of the present invention is provided, and the cooling device 1 is the cooling device 1 according to the embodiment in the first aspect of the present invention.

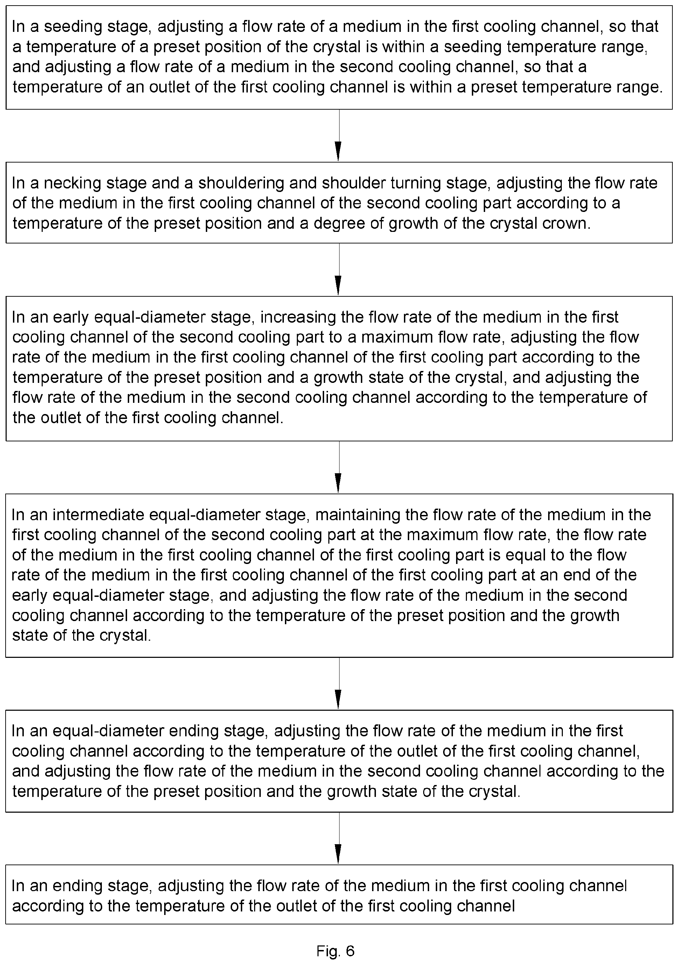

As shown in Fig. 6, the control method includes the following steps.

At S1, in a seeding stage, adjusting a flow rate of a medium in the first cooling channel, so that a temperature of a first preset position of the crystal 101 is within a seeding temperature range, and adjusting a flow rate of a medium in the second cooling channel, so that a temperature of an outlet of the first cooling channel is within a preset temperature range.

For example, in the seeding stage, the first cooling jacket 11 of the cooling device 1 may be used for leading the heat dissipation of the crystal 101, and the temperature of the first preset position of the crystal 101 may be obtained in real time, so as to adjust the flow rate of the medium in the first cooling channel according to the obtained result, so that the temperature of the first preset position tends to be within the seeding temperature range, which is convenient to ensure the seeding efficiency and the seeding effect. For example, if the temperature of the first preset position is relatively high, the flow rate of the medium in the first cooling channel may be appropriately increased, and if the temperature of the first preset position is relatively low, the flow rate of the medium in the first cooling channel may be appropriately reduced, so that the temperature of the first preset position is finally maintained within the seeding temperature range. At the same time, the temperature of the outlet of the first cooling channel may be obtained in real time to adjust the flow rate of the medium in the second cooling channel according to the obtained result, so as to adjust the cooling capacity of the second cooling jacket 12 to adjust the heat dissipated by the first cooling jacket 11, thereby achieving the purpose of adjusting the temperature of the outlet of the first cooling channel, so that the temperature of the outlet of the first cooling channel meets the above requirements, for example, if the temperature of the outlet of the first cooling channel is relatively high, the flow rate of the medium in the second cooling channel may be appropriately increased, and if the temperature of the outlet of the first cooling channel is relatively low, the flow rate of the medium in the second cooling channel may be appropriately reduced.

Therefore, the cooling capability of the cooling device 1 is more matched with the heat dissipation requirement in the seeding stage, so as to better ensure the seeding efficiency and the seeding effect, thereby laying a good foundation for the growth of the crystal 101.

It can be seen that the first cooling channel is provided with an inlet and an outlet, so that the cooling medium may flow in the first cooling channel and take away the heat that needs to be dissipated in the seeding stage in time.

Wherein, the seeding temperature range and the preset temperature range may be specifically set according to actual requirements. It is understandable that in S1, the order of "adjusting the flow rate of the medium in the first cooling channel" and "adjusting the flow rate of the medium in the second cooling channel" is not fixed, the flow rate of the medium in the first cooling channel may be adjusted first, and then the flow rate of the medium in the second cooling channel may be adjusted, or the flow rate of the medium in the second cooling channel may also be adjusted first, and then the flow rate of the medium in the first cooling channel may be adjusted, or the flow rate of the medium in the first cooling channel and the flow rate of the medium in the second cooling channel may be adjusted at the same time.

Optionally, the medium in the first cooling channel may be maintained at a uniform flow speed.

The control method for the cooling device 1 according to the embodiment of the present invention is convenient to effectively ensure the cooling requirement in the early growth stage of the crystal 101, especially the cooling requirement in the seeding stage.

In some embodiments, as shown in Fig. 1 and Fig. 2, the first cooling jacket 11 includes a first cooling part 111 and a second cooling part 112. The first cooling part 111 is formed into a cylindrical structure, and the first cooling part 111 defines the first cooling channel. The second cooling part 112 covers an upper end of the first cooling part 111, the second cooling part 112 is fixedly connected with the crystal pulling mechanism 4, the second cooling part 112 defines the first cooling channel, and the first cooling channel of the second cooling part 112 and the first cooling channel of the first cooling part 111 are independently arranged, so that the flow rate of the medium of the first cooling part 111 and the flow rate of the medium of the second cooling part 112 are independently adjusted, that is, changes in the flow rate of the medium of the first cooling part 111 do not affect the flow rate of the medium of the second cooling part 112, and changes in the flow rate of the medium of the second cooling part 112 do not affect the flow rate of the medium of the first cooling part 111, so as to flexibly regulate the cooling capacity of the first cooling jacket 11, thereby better meeting different cooling requirements in different growth stages of the crystal 101.

In some embodiments, in S1, the flow rate of the medium in the first cooling part 111 is equal to the flow rate of the medium in the second cooling part 112, which facilitates simplifying the adjustment of the flow rate of the medium in the first cooling channels, and is conductive to improving the adjustment rate.

In some embodiments, as shown in Fig. 6, the control method further includes the following steps: S2, in a necking stage and a shouldering and shoulder turning stage, adjusting the flow rate of the medium in the first cooling channel of the second cooling part 112 according to a temperature of a second preset position and a degree of growth of the crystal crown 101a, so that the cooling effect of the second cooling part 112 on the crystal crown 101a better meets the growth requirement of the crystal crown 101a.

The necking stage and the shouldering and shoulder turning stage may be understood as the growth stage of the crystal crown 101a, and the degree of growth of the crystal crown 101a may be understood as the area of an upper surface of the crystal crown 101a.

Optionally, in the necking stage and the shouldering and shoulder turning stage, as the crystal crown 101a grows, the flow rate of the medium in the first cooling channel of the second cooling part 112 is gradually increased; and as the temperature of the second preset position increases, the flow rate of the medium in the first cooling channel of the second cooling part 112 is increased.

As shown in Fig. 6, the control method further includes the following steps.

At S3, in an early equal-diameter stage, increasing the flow rate of the medium in the first cooling channel of the second cooling part 112 to a maximum flow rate, adjusting the flow rate of the medium in the first cooling channel of the first cooling part 111 according to the temperature of the second preset position and a growth state of the crystal 101, and adjusting the flow rate of the medium in the second cooling channel according to the temperature of the outlet of the first cooling channel, so that the cooling capacity of the second cooling jacket 12 is matched with the cooling capacity of the first cooling jacket 11, and the cooling capacity of the second cooling jacket 12 and the cooling capacity of the first cooling jacket 11 are matched with the growth requirement of the crystal 101.

Wherein, in the description of the present invention, the growth state of the crystal 101 may include at least one of a growth diameter of the crystal 101 and an internal defect of the crystal 101. For example, in the early equal-diameter stage, if the temperature of the second preset position increases, the flow rate of the medium in the first cooling channel of the first cooling part 111 is increased; if a difference between the growth diameter of the crystal 101 and a preset diameter is greater than a first preset value, the flow rate of the medium in the first cooling channel of the first cooling part 111 is reduced; if the difference between the growth diameter of the crystal 101 and the preset diameter is less than a second preset value, the flow rate of the medium in the first cooling channel of the first cooling part 111 is increased; when the difference between the growth diameter of the crystal 101 and the preset diameter is greater than or equal to the second preset value and less than or equal to the first preset value, the flow rate of the medium in the first cooling channel of the first cooling part 111 remains unchanged; and when it is detected that the internal defect of the crystal 101 is formed, the flow rate of the medium in the first cooling channel of the first cooling part 111 is reduced.

Optionally, in the early equal-diameter stage, if the temperature of the outlet of the first cooling channel is reduced, the flow rate of the medium in the second cooling channel is reduced, and on the contrary, if the temperature of the outlet of the first cooling channel is increased, the flow rate of the medium in the second cooling channel is increased.

The maximum flow rate may be specifically set according to actual requirements.

At S4, in an intermediate equal-diameter stage, maintaining the flow rate of the medium in the first cooling channel of the second cooling part 112 at the maximum flow rate, the flow rate of the medium in the first cooling channel of the first cooling part 111 is equal to the flow rate of the medium in the first cooling channel of the first cooling part 111 at an end of the early equal-diameter stage, and adjusting the flow rate of the medium in the second cooling channel according to the temperature of the second preset position and the growth state of the crystal 101.

Optionally, when it is detected that the internal defect of the crystal 101 is formed, the flow rate of the medium in the second cooling channel is reduced.

At S5, in an equal-diameter ending stage, adjusting the flow rate of the medium in the first cooling channel according to the temperature of the outlet of the first cooling channel, and adjusting the flow rate of the medium in the second cooling channel according to the temperature of the second preset position and the growth state of the crystal 101.

As shown in Fig. 6, the control method further includes the following step: S6, in an ending stage, adjusting the flow rate of the medium in the first cooling channel according to the temperature of the outlet of the first cooling channel, so that the cooling capacity of the first cooling jacket 11 meets the cooling requirement of the crystal 101 in the ending stage.

Optionally, in the ending stage, the temperature of the second preset position is gradually reduced, the flow rate of the medium in the first cooling channel is gradually reduced, and until the temperature of the outlet of the first cooling channel is slightly increased, the flow rate of the medium in the first cooling channel is not reduced any more.

Optionally, in the ending stage, the flow rate of the medium in the second cooling channel may be adjusted according to a conventional process, and the specific regulation and control manner is well known to those skilled in the art, which will not be elaborated herein.

Optionally, the first preset position and the second preset position are different positions, the first preset position may be any position on the crystal diameter, and the second preset position is preferably a lower edge of the crystal crown 101a.

Optionally, the first preset position and the second preset position may be the same position, and may specifically be the lower edge of the crystal crown 101a, the crystal crown is not grown in the seeding stage, and the temperature of the lower edge of the crystal crown 101a may be determined according to the actually measured temperature result obtained in the previous growth process of the crystal or according to the simulation result.

Other configurations and operations of the crystal growth apparatus 100 according to the embodiments of the present invention are known to those of ordinary skill in the art, and will not be elaborated herein.

Although the embodiments of the present invention have been shown and described, those of ordinary skill in the art may understand that various changes, modifications, substitutions and variations may be made to these embodiments without departing from the principle and purpose of the present invention, and the scope of the present invention is defined by the claims and their equivalents.

## Claims

1. A cooling device, wherein the cooling device (1) is used for a crystal growth apparatus (100) and is used for cooling a crystal (101), and a top of the crystal (101) is provided with a crystal crown (101a);
the cooling device (1) comprises:
a first cooling jacket (11), wherein the first cooling jacket (11) is configured to be fixedly connected with a crystal pulling mechanism (4) of the crystal growth apparatus (100) and
covers an upper side of the crystal crown (101a), the first cooling jacket (11) rises along with a lifting of the crystal pulling mechanism (4) during a growth process of the crystal, an inner wall face of the first cooling jacket (11) is spaced from a surface of the crystal (101), and the first cooling jacket (11) defines at least one first cooling channel; and
a second cooling jacket (12), wherein the second cooling jacket (12) is formed into a cylindrical structure, and is configured to be fixedly arranged in a furnace body (2) of the crystal growth apparatus (100), an orthographic projection of the second cooling jacket (12) is nested outside an orthographic projection of the first cooling jacket (11) in a cross-section of the cooling device (1), the second cooling jacket (12) defines a second cooling channel, and is used for cooling different parts of the crystal (101) during the growth process of the crystal (101); and
an axial length of the first cooling jacket (11) is less than an axial length of the second cooling jacket (12).

2. The cooling device according to claim 1, wherein a first through hole (11a) is formed on the first cooling jacket (11), and the crystal pulling mechanism (4) is configures to pass through the first through hole (11a).

3. The cooling device according to claim 1, wherein a plurality of second through holes (11b) are formed at a top of the first cooling jacket (11), and the plurality of second through holes (11b) are arranged at intervals in a circumferential direction of the cooling device (1), so that a protective gas flows into a space between the cooling device (1) and the crystal (101) through the second through holes (11b).

4. The cooling device according to claim 1, wherein the first cooling jacket (11) comprises:
a first cooling part (111), wherein the first cooling part (111) is formed into a cylindrical structure, and defines the first cooling channel; and
a second cooling part (112), wherein the second cooling part (112) covers an upper end of the first cooling part (111), and is fixedly connected with the crystal pulling mechanism (4), the second cooling part (112) defines the first cooling channel, and the first cooling channel of the second cooling part (112) and the first cooling channel of the first cooling part (111) are independently arranged.

5. The cooling device according to claim 4, wherein a shape of an inner wall face of the second cooling part (112) is consistent with a shape of a surface of the crystal crown (101a).

6. The cooling device according to claim 4, wherein at least one of an outer peripheral wall of the first cooling part (111) and an inner peripheral wall of the second cooling jacket (12) is formed into a curve segment in a longitudinal section of the cooling device (1).

7. The cooling device according to any one of claims 1 to 6, wherein an outer peripheral wall of the second cooling jacket (12) is provided with a heat dissipation structure (13).

8. The cooling device according to claim 7, wherein the heat dissipation structure (13) comprises a plurality of heat dissipation groups sequentially arranged in an axial direction of the second cooling jacket (12); and for at least two adjacent heat dissipation groups, a heat dissipation area per unit length of the heat dissipation group on a lower side in the axial direction of the second cooling jacket (12) is greater than a heat dissipation area per unit length of the heat dissipation group on an upper side in the axial direction of the second cooling jacket (12).

9. The cooling device according to claim 7, wherein the heat dissipation structure (13) comprises:
at least one fin group, wherein each fin group comprises a plurality of heat dissipation fins, the plurality of heat dissipation fins of the fin group being arranged at intervals in an axial direction and/or a circumferential direction of the second cooling jacket (12).

10. A crystal growth apparatus, comprising a furnace body (2) and the cooling device (1) according to any one of claims 1 to 9, wherein the cooling device (1) is arranged in the furnace body (2) and is used for cooling the crystal (101).

11. A control method for a cooling device, wherein the cooling device is the cooling device according to any one of claims 1 to 9, and the control method comprises following steps:
S1, in a seeding stage, adjusting a flow rate of a medium in the first cooling channel, so that a temperature of a first preset position of the crystal is within a seeding temperature range, and adjusting a flow rate of a medium in the second cooling channel, so that a temperature of an outlet of the first cooling channel is within a preset temperature range.

12. The control method for the cooling device according to claim 11, wherein the first cooling jacket comprises a first cooling part and a second cooling part, wherein the first cooling part is formed into a cylindrical structure, and defines the first cooling channel; and the second cooling part covers an upper end of the first cooling part, and is fixedly connected with the crystal pulling mechanism, the second cooling part defines the first cooling channel, and the first cooling channel of the second cooling part and the first cooling channel of the first cooling part are independently arranged.

13. The control method for the cooling device according to claim 12, wherein in S1, a flow rate of a medium in the first cooling part is equal to a flow rate of a medium in the second cooling part.

14. The control method for the cooling device according to claim 12, wherein the control method further comprising:
S2, in a necking stage and a shouldering and shoulder turning stage, adjusting the flow rate of the medium in the first cooling channel of the second cooling part according to a temperature of a second preset position and a degree of growth of the crystal crown;
S3, in an early equal-diameter stage, increasing the flow rate of the medium in the first cooling channel of the second cooling part to a maximum flow rate, adjusting the flow rate of the medium in the first cooling channel of the first cooling part according to the temperature of the second preset position and a growth state of the crystal, and adjusting the flow rate of the medium in the second cooling channel according to the temperature of the outlet of the first cooling channel;
S4, in an intermediate equal-diameter stage, maintaining the flow rate of the medium in the first cooling channel of the second cooling part at the maximum flow rate, wherein the flow rate of the medium in the first cooling channel of the first cooling part is equal to the flow rate of the medium in the first cooling channel of the first cooling part at an end of the early equal-diameter stage, and adjusting the flow rate of the medium in the second cooling channel according to the temperature of the second preset position and the growth state of the crystal;
S5, in an equal-diameter ending stage, adjusting the flow rate of the medium in the first cooling channel according to the temperature of the outlet of the first cooling channel, and adjusting the flow rate of the medium in the second cooling channel according to the temperature of the second preset position and the growth state of the crystal; and
S6, in an ending stage, adjusting the flow rate of the medium in the first cooling channel according to the temperature of the outlet of the first cooling channel.
